# FASCICULE DE BREVET EUROPEEN

(11) **EP 2 863 420 B1**
(45) Date de publication et mention de la délivrance du brevet: **13.03.2019**
(21) Numéro de dépôt: 14187420.6
(22) Date de dépôt: 02.10.2014
(51) Int. Cl.: H01L 21/60, H01L 25/065

(54) **Procédé amélioré d'assemblage par collage direct entre deux éléments, chaque élément comprenant des portions de métal et de matériaux diélectriques**
Verbessertes Verfahren zum Zusammenbau durch direktes Bonden von zwei Elementen, wobei jedes Element Metallanteile und Anteile aus dielektrischem Material umfasst
Improved method for assembly by direct bonding between two elements, each element comprising portions of metal and dielectric materials

(30) Priorité: 03.10.2013 FR 1359591
(43) Date de publication de la demande: 22.04.2015
(73) Titulaire: Commissariat à l'Énergie Atomique et aux Énergies Alternatives, 75015 Paris (FR); STMicroelectronics (Crolles 2) SAS, 38920 Crolles (FR)
(72) Inventeur: Di Cioccio, Léa, 38330 Saint Ismier (FR); Beilliard, Yann, 26120 Upie (FR)
(74) Mandataire: Brevalex

(56) Documents cités:
- WO-A1-2012/130730
- FR-A1- 2 913 145
- FR-A1- 2 963 158
- US-A1- 2012 100 657
- SUGA T ET AL: "Surface activated bonding for new flip chip and bumpless interconnect systems", 2002 PROCEEDINGS 52ND. ELECTRONIC COMPONENTS AND TECHNOLOGY CONFERENCE. ECTC 2002. SAN DIEGO, CA, MAY 28 - 31, 2002; [PROCEEDINGS OF THE ELECTRONIC COMPONENTS AND TECHNOLOGY CONFERENCE], NEW YORK, NY : IEEE, US, vol. CONF. 52, 28 mai 2002 (2002-05-28), pages 105-111, XP010747615, DOI: 10.1109/ECTC.2002.1008081 ISBN: 978-0-7803-7430-0

## Description

### DOMAINE TECHNIQUE ET ART ANTÉRIEUR

La présente invention se rapporte à un procédé amélioré d'assemblage de deux éléments par collage direct, la surface à assembler d'au moins l'un de ces éléments comprenant à la fois des portions en métal et des portions en matériau diélectrique, ce procédé est notamment utilisable dans la réalisation de dispositifs microélectroniques et nanoélectroniques.

L'intégration en trois dimensions dans les dispositifs microélectroniques et nanoélectroniques permet de réduire la taille des dispositifs, de réduire leur consommation électrique, d'augmenter les vitesses de transmission, les performances, la fréquence de fonctionnement, etc.

Une intégration en trois dimensions peut comporter notamment les étapes de collage avec alignement des plots de connexion, d'amincissement et d'interconnexion verticale à travers l'empilement.

On utilise la technologie TSV (Through Silicon Via) qui consiste à réaliser des via de connexion à travers le silicium. Cependant pour obtenir une densité d'interconnexion élevée et pour simplifier la technologie, il est préférable d'assembler les éléments, et en particulier les connexions par un collage métal-métal directement.

Par exemple le cuivre est un des métaux qui est particulièrement utilisé pour réaliser des plots de connexion.

Une technique d'assemblage de tels éléments est la thermocompression. Cette technique consiste à mettre les éléments en contact l'un avec l'autre et à appliquer une pression importante, par exemple entre 4 kN et 10 kN sur l'un des éléments en direction de l'autre élément. En général un recuit a ensuite lieu, la pression n'étant alors plus appliquée. Le recuit peut également avoir lieu lorsque la pression est appliquée. L'application de cette pression vise à écraser les aspérités de surface afin d'augmenter la surface de contact pour permettre une diffusion atomique des atomes métalliques.

Les surfaces à assembler peuvent être composées de portions de cuivre séparées par des portions de matériau diélectrique ou, plus généralement, de portions de métal délimitées au sein d'une surface de matériau diélectrique.

Dans le cas d'un assemblage par thermocompression, les portions en cuivre sont en saillie par rapport aux matériaux diélectriques qui les entourent.

L'assemblage est également obtenu par écrasement d'aspérités.

Cependant l'application d'une pression peut endommager les dispositifs microélectroniques et nanoélectroniques. Par ailleurs, on souhaite lors de l'assemblage aligner le mieux possible les plots de cuivre d'un élément avec ceux de l'autre élément. Or avec la technique d'assemblage par thermocompression, l'alignement obtenu peut ne pas être satisfaisant.

Il existe une technique permettant d'obtenir une qualité d'alignement sensiblement meilleure, il s'agit de la technique de collage direct.

Cette technique de collage prévoit une préparation particulière des surfaces à mettre en contact en termes de rugosité et d'hydrophilie.

Dans le cas où les surfaces à assembler sont composées de portions de cuivre séparées par des portions de matériau diélectrique, les portions de cuivre sont en retrait ou en "recess" par rapport au matériau diélectrique qui les entourent, et lors de la mise en contact ce sont les portions de diélectrique, par exemple les portions oxyde qui entrent en contact. Cette première étape de mise en contact peut avoir lieu à température ambiante et à pression atmosphérique sans application de pression.

Ensuite a lieu un traitement thermique par exemple à une température de 400°C, lors duquel les portions de cuivre en regard se dilatent et entrent en contact et se scellent.

Cette technique est par exemple décrite dans le document "An Overview of Patterned Metal/Dielectric Surface Bonding: Mechanism, Alignement and Characterization, L. Di Cioccio and Al, Journal of Electrochemical Society, Vol. 158, Issue 6, p81-86, 2011*.*

Un procédé similaire est décrit aussi dans les documents US 2012/0100657 et FR 2913145.

Le comblement du retrait par dilatation est possible si les portions de cuivre ne sont pas trop en retrait, cette profondeur de retrait est également appelée "dishing". Si le dishing est trop grand, les portions de cuivre n'entrent pas en contact lors du traitement thermique et les contacts électriques entre les plots en cuivre des deux éléments ne sont pas satisfaisants.

### EXPOSÉ DE L'INVENTION

C'est par conséquent un but de la présente invention d'offrir un procédé amélioré d'assemblage par collage direct de structures comportant des surfaces mixtes en regard, les surfaces mixtes comportant du métal et un ou des matériaux diélectriques, permettant d'obtenir un bon scellement entre les portions métalliques malgré un dishing important.

Le but précédemment énoncé est atteint par un procédé d'assemblage comportant une étape de mise en contact d'au moins une surface mixte portée par un élément et d'une surface d'un autre élément sans application de pression, et une étape de traitement thermique de l'ensemble, lors de laquelle les deux éléments sont maintenus en contact l'un de l'autre sans application de pression.

Les inventeurs ont constaté qu'un simple maintien des éléments à assembler permettait d'obtenir un scellement entre au moins une portion de métal en retrait et une autre surface qui peut comporter au moins une portion de métal en retrait, même dans le cas d'un dishing important.

En d'autres termes, on maintient les éléments à assembler de telle manière que l'empilement, par exemple pendant le traitement thermique, ait sensiblement la même épaisseur que celle de l'empilement après l'étape de mise en contact de sorte à faciliter la mise en contact des plots métalliques lors de leur dilatation lorsque les deux éléments comportent des plots métalliques. En immobilisant les éléments, on favorise la mise en contact des portions de métal et leur scellement.

Grâce à la présente invention, il est possible de réaliser un traitement thermique à plus basse température ou alors d'obtenir un collage satisfaisant avec un dishing initial plus important sans changer la température du traitement thermique.

On peut prévoir avant l'étape de mise en contact ou avant ou pendant le traitement thermique, une étape de remise à plat de l'un ou des deux éléments à assembler dans le cas d'un défaut de planéité, par exemple en appliquant une force inférieure à 3 kN.

La présente invention a alors pour objet un procédé d'assemblage par collage direct d'un premier et d'un deuxième élément munis chacun d'une face arrière et d'une surface d'assemblage, au moins la surface d'assemblage du premier élément comportant au moins une portion au moins en partie métallique entourée par au moins un matériau diélectrique, ladite portion métallique présentant une surface libre en retrait par rapport au matériau diélectrique au niveau de ladite surface d'assemblage, ledit procédé comportant :
A) une étape de mise en contact des deux surfaces d'assemblage sans application de pression de sorte qu'un collage direct soit obtenu entre les surfaces d'assemblage, ladite étape ayant lieu à au moins une première température, lesdits premier et deuxième ensembles formant un empilement présentant une épaisseur,
B) une étape de traitement thermique dudit empilement à au moins une deuxième température,
procédé dans lequel, pendant au moins une première phase de l'étape B), les faces arrière des premier et deuxième éléments sont immobilisées de sorte qu'elles soient maintenues à distance fixe comprise entre l'épaisseur de l'empilement - 2 nm et l'épaisseur de l'empilement + 2 nm.

De préférence, lors de l'étape B), les faces arrière des premier et deuxième éléments sont immobilisées de sorte qu'elles soient maintenues à distance fixe comprise entre l'épaisseur de l'empilement - 1 nm et l'épaisseur de l'empilement + 1 nm.

Par exemple, la surface d'assemblage du deuxième élément comporte au moins une portion au moins en partie métallique entourée par au moins un matériau diélectrique, ladite portion métallique présentant une surface libre en retrait par rapport au matériau diélectrique au niveau de ladite surface d'assemblage, et dans lequel, lors de l'étape A), la mise en contact est réalisée de sorte à aligner la portion métallique de la surface d'assemblage du premier élément et la portion métallique de la surface d'assemblage du deuxième élément.

Lors de l'étape B), l'empilement peut être disposé entre deux dispositifs de maintien destinés à être en contact plan contre les faces arrière des premier et deuxième éléments, la distance séparant les deux dispositifs de maintien étant comprise entre l'épaisseur de l'empilement - 2 nm et l'épaisseur de l'empilement + 2 nm.

La deuxième température du traitement thermique peut être réglée en fonction du retrait des portions métalliques par rapport au matériau diélectrique au niveau des surfaces d'assemblages.

De préférence, le retrait des surfaces des portions métalliques par rapport à la surface de matériau diélectrique est inférieur ou égal à 20 nm.

L'étape A) a avantageusement lieu à température ambiante et à pression atmosphérique.

La au moins deuxième température de l'étape de traitement thermique peut être comprise entre 50°C et 400°C.

Dan une variante du procédé d'assemblage, lorsque l'empilement présente une courbure, le procédé peut comporter une étape de remise à plat de l'empilement avant ou après l'étape A) et avant et/ou pendant le traitement thermique afin de supprimer ladite courbure. De préférence, une force d'intensité de valeur inférieure à 3 kN est appliquée à l'empilement de sorte à supprimer la courbure.

Préalablement à l'étape A), a avantageusement lieu :
a) au moins une étape de polissage des surfaces d'assemblage de sorte que les surfaces présentent une rugosité inférieure à 0,7 nm RMS, et une hydrophilie inférieure à 20°.

De manière avantageuse, lors de l'étape B), les faces arrière des premier et deuxième éléments sont maintenues à distance fixe (E) pendant une première phase et le maintien est supprimé pendant une deuxième phase, la deuxième phase pouvant se dérouler à la même température ou à une température différente de celle de la première phase.

Les surfaces desdits dispositifs de maintien sont de préférence au moins égales à la surface des faces arrière des premier et deuxième éléments.

Les portions métalliques peuvent être en cuivre, en aluminium, en tungstène, en titan et le matériau diélectrique peut être un oxyde ou un nitrure, tel que SiO₂, SiOCH, Si₃N₄, du Al₂O₃.

Le procédé peut assembler plusieurs premiers éléments à plusieurs deuxièmes éléments simultanément.

Le premier et le deuxième élément peuvent être des substrats microélectroniques et/ou nanoélectroniques, les portions métalliques formant des interconnexions électriques.

### BRÈVE DESCRIPTION DES DESSINS

La présente invention sera mieux comprise à l'aide de la description qui va suivre et des dessins en annexe sur lesquels :
- la figure 1 est une représentation schématique d'un exemple de deux éléments à assembler,
- les figures 2A à 2C sont des représentations schématiques d'étapes du procédé selon un exemple de réalisation,
- la figure 3 est une représentation schématique d'une variante de réalisation de l'étape de traitement thermique, dans laquelle le maintien est assuré par deux pistons,
- la figure 4 est une représentation schématique d'un autre exemple d'éléments pouvant être assemblés par le procédé selon l'invention,
- la figure 5 est une représentation schématique d'un autre exemple d'éléments pouvant être assemblés par le procédé selon l'invention,
- la figure 6 est une représentation graphique du déplacement en µm de la zone centrale libre d'un plot de cuivre en fonction de son diamètre en µm lorsqu'il subit un traitement thermique à 200°C pour différentes hauteur du plot en µm.

### EXPOSÉ DÉTAILLÉ DE MODES DE RÉALISATION PARTICULIERS

Dans un exemple de réalisation, le procédé selon la présente invention consiste à réaliser un assemblage par un collage direct par exemple entre deux surfaces comprenant des portions métallique, par exemple de cuivre et des portions de matériau diélectrique, par exemple du SiO₂. En variante, il est possible, que l'une au moins des surfaces comprenne des portions métalliques délimitées par des portions de matériau diélectrique au sein de portions d'un troisième matériau, par exemple un matériau semiconducteur

Les portions métalliques dans des dispositifs microélectroniques et nanoélectroniques remplissent une fonction de plots de connexion et présentent des dimensions suffisantes pour remplir cette fonction.

L'assemblage de deux éléments dont les surfaces à mettre en contact n'ont pas la même structure ne sort pas du cadre de la présente invention. Par exemple, la présente invention s'applique à l'assemblage d'un élément ayant une ou des portions métalliques entourées de portions diélectriques et d'un élément comportant au niveau de sa face d'assemblage uniquement une couche métallique.

L'invention s'applique également à l'assemblage de deux éléments dont l'un ou les deux comportent une couche recouvrant les portions métalliques et les portions diélectriques, par exemple une couche de diélectrique, par exemple une couche d'oxyde.

Le collage direct, parfois appelé collage moléculaire, est compris comme la mise en contact de deux surfaces sensiblement planes au cours de laquelle ces deux surfaces sensiblement planes adhèrent l'une à l'autre sans ajout de matière adhésive.

Dans la description qui va suivre, le procédé selon la présente invention sera décrit dans le cadre du collage de deux éléments destinés aux réalisations de dispositifs microélectroniques ou nanoélectroniques, plus particulièrement pour réaliser la connexion de plots de connexion en cuivre, mais le procédé selon la présente invention s'applique au collage de portions métalliques qui ne sont pas nécessairement des plots de connexion. Il peut s'agir par exemple de vias traversants. En outre, le procédé selon l'invention peut être mis en oeuvre dans tous les domaines dans lesquels on souhaite assembler des surfaces mixtes.

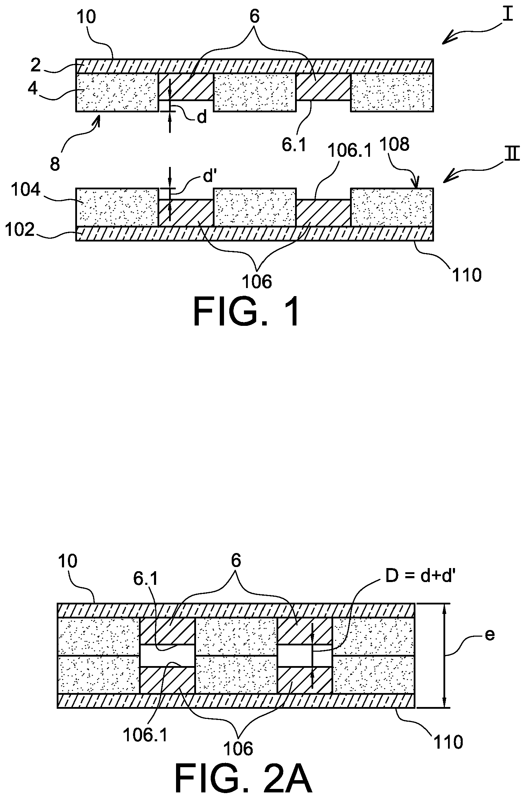

Sur la figure 1, on peut voir représenté schématiquement un exemple de premier I et de deuxième II élément destinés à être assemblés par le procédé selon la présente invention.

Le premier élément I comporte une surface d'assemblage 8 et une face arrière 10. Le premier élément est formé d'un substrat 2, par exemple en silicium, d'une couche de matériau diélectrique 4, par exemple en SiO₂, de plots en métal, par exemple en cuivre 6 dans des zones gravées du matériau diélectrique 4. Les plots 6 présentent une surface libre 6.1 en retrait d'une surface libre de la couche 4 qui correspond à la surface d'assemblage. Ce retrait est appelé dishing. La profondeur de ce dishing est désignée d.

Ce dishing se forme lors des étapes de polissage d'une surface mixte.

Le deuxième élément II, qui est représenté sur la figure 1, est de structure similaire. Il comporte une surface d'assemblage 108 et une face arrière 110. Le deuxième élément II est formé d'un substrat 102, par exemple en silicium, d'une couche de matériau diélectrique 104, par exemple en SiO₂, disposée sur le substrat 102, de plots en métal, par exemple en cuivre 106 dans des zones gravées du matériau diélectrique 104. Les plots 106 présentent une surface libre 106.1 en retrait d'une surface libre de la couche 104 qui correspond à la surface d'assemblage. Ce retrait appelé dishing. La profondeur de ce dishing est désigné d'.

Alternativement le métal des portions métalliques peut être de l'aluminium, du tungstène, du titane, etc.

Alternativement le matériau diélectrique peut être plus généralement un oxyde ou un nitrure, tel que du SiOCH, Si₃N₄, Al2O3, etc.

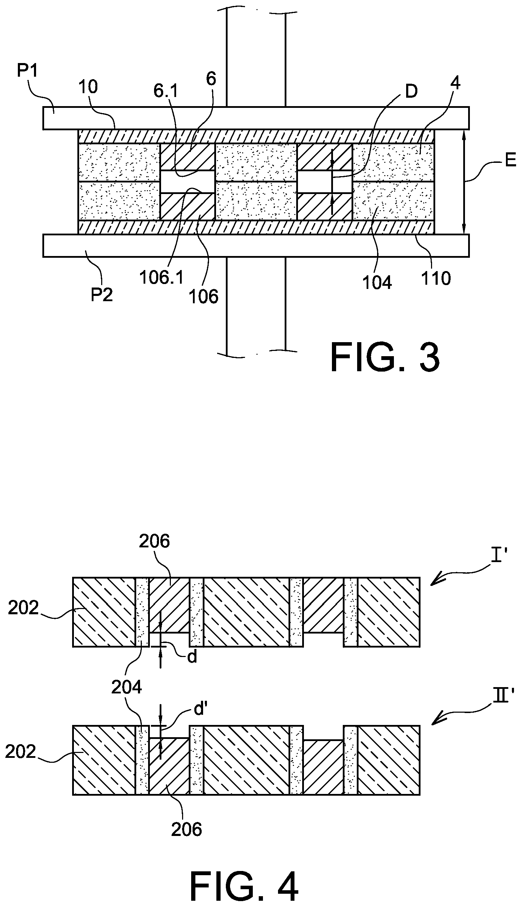

En variante, comme cela est représenté sur la figure 4, les éléments I" et II" pourraient comporter des plots 206 traversant l'intégralité du substrat 202 formant des vias traversants (TSV : "Through Silicon Via" en anglais), en étant isolés électriquement de ce substrat par une zone diélectrique 204 entourant les plots 206.

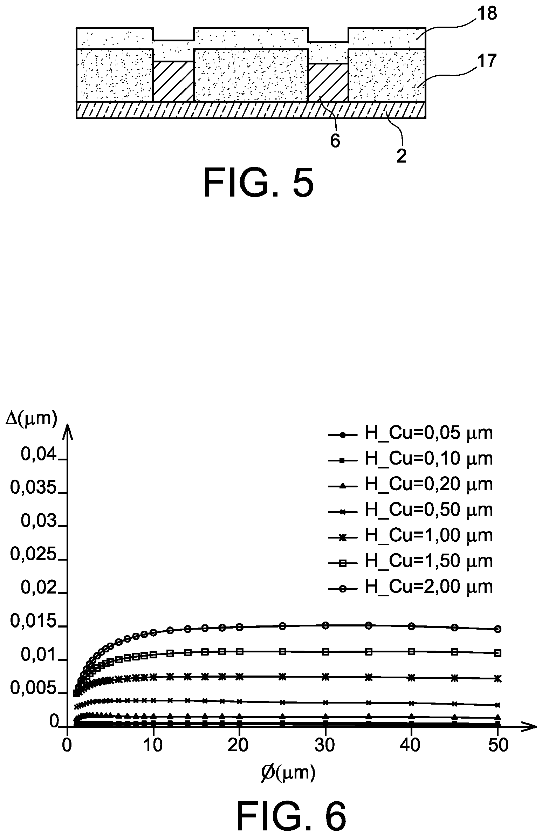

Sur la figure 5, on peut voir une autre variante d'un élément pouvant être assemblé, celui-ci comportant par exemple une couche 18 recouvrant à la fois les plots métalliques 6 et le matériau diélectrique. Le matériau de la couche 18 peut être un diélectrique, un oxyde ou un nitrure notamment. En variante, le matériau de la couche 18 peut être choisi parmi la liste suivante : CoWB, CoWP, NiP, NiWB, NiW, NiB, NiReP, NiMoP, NiWP, CoWPB, CoWBO, CoMoPO, la couche 18 formant par exemple une barrière de diffusion.

Le procédé d'assemblage selon l'invention comporte :
A) une étape de mise en contact des surfaces des éléments sans application de pression,
B) une étape de traitement thermique de l'empilement formé à l'étape A).

On entend dans la présente demande par "sans application de pression", l'absence d'une pression extérieure appliquée aux éléments lorsqu'ils sont en contact, seul le poids de l'élément du dessus assurant un contact. Dans le cas d'une étape de remise à plat qui sera décrite ultérieurement, on entend par "sans application de pression", l'application d'une force inférieure à 3 kN voire inférieure à 1 kN.

Les surfaces mises en contact pour obtenir un collage direct présentent une rugosité et une hydrophilie permettant un collage direct au niveau de ces zones en contact dès leur mise en contact.

De préférence, la rugosité est inférieure à 0,7 nm RMS (Root Mean Square), de manière encore préférée inférieure ou égale à 0,3 nm RMS. Cette rugosité est obtenue par polissage, par exemple polissage mécano-chimique ou CMP ("Chemical Mechanical Polishing" en terminologie anglo-saxonne). De préférence les surfaces présentent un caractère hydrophile. Ce caractère hydrophile est par exemple obtenu après une étape de nettoyage des dites surfaces afin de supprimer la présence de particules dues au polissage. Avantageusement une étape de réactivation d'au moins les portions de matériau diélectrique peut être prévue avant l'étape de mise en contact de sorte que les surfaces présentent un caractère hydrophile. Dans la présente demande, une surface est considérée comme hydrophile si l'angle de contact est compris entre 0° et 20°, de préférence celui-ci est le plus faible possible. De préférence, la surface présente une hydrophilie inférieure ou égale à 10°.

Les conditions pour réaliser le polissage mécano-chimique pour le collage cuivre-cuivre sont par exemple décrites dans le document *"*Enabling 3D Interconnects with Metal Direct Bonding", Di Cioccio et Al., Proceedings of the 2009 IEEE International Interconnect Technology Conference, pages 152-154, 2009*".* Des conditions similaires s'appliquent pour la préparation des autres matériaux, en adaptant le procédé aux matériaux mis en jeu, par exemple les pâtes utilisées pour le polissage, plus couramment désignées slurries, sont choisies en fonction du ou des matériaux mis en oeuvre.

Après le polissage, la surface libre des plots 6.1, 106.1 en cuivre a alors un profil en cuvette, en retrait des surfaces libres de portions en matériau diélectrique.

De préférence, la profondeur ou dishing d, d' de ces cuvettes est inférieur à 20 nm.

Le dishing des cuvettes peut être contrôlé par les paramètres de polissage, par exemple par la pression, le temps de polissage et le choix du ou des slurries. Il est fonction également de la surface des plots et de leur densité.

Selon un exemple de réalisation, l'étape A) de mise en contact des deux éléments s'effectue comme suit :
Les deux surfaces d'assemblage 8, 108 des éléments sont mises face à face, les plots de cuivre 6 sont sensiblement mis en regard avec les plots de cuivre 106 et les surfaces sont mises en contact. Comme expliqué précédemment, les faces libres 6.1, 106.1 des plots de cuivre 6, 106 sont en retrait des surfaces, le dishing est par exemple compris entre 5 nm et 10 nm sur un plot métallique de 5 µm de côté et 500 nm de haut.

Les surfaces des portions diélectriques entrent au contact et adhérent par collage direct hydrophile, ce collage direct peut être obtenu à température ambiante et à pression atmosphérique. Du fait des dishings qui existent sur les deux faces de cuivre en regard, les faces de cuivre ne sont pas en contact lors de cette étape A). A la fin de l'étape a), les faces libres des portions 6 et 106 en regard sont séparées d'une distance D = d + d' (figure 2A).

L'empilement ainsi formé à la fin de l'étape A) présente une épaisseur e définie entre les faces arrière des éléments. Dans ce mode de réalisation, aucun maintien des éléments l'un contre l'autre n'est requis.

Lors d'une étape suivante, on applique un traitement thermique à l'empilement ainsi formé afin de mettre en contact les plots de cuivre des deux éléments.

Par exemple, la température du traitement thermique peut être de l'ordre de 400°C.

Pendant cette étape de traitement thermique, les deux éléments sont maintenus à distance constante par un outil de maintien. Pour cela, par exemple on dispose l'empilement entre deux plaques définissant entre elles une distance fixe E. Cette distance E est comprise entre [e - 2 nm ; e +2 nm], de préférence entre [e - 1 nm; e + 2 nm]. Les plaques forment par exemple un ensemble d'une seule pièce. Par exemple, l'empilement est glissé entre les plaques.

Ainsi, les deux éléments sont maintenus l'un contre l'autre mais aucun effort de rapprochement n'est appliqué. Les éléments de maintien ont pour fonction d'empêcher les éléments de s'écarter l'un de l'autre au-delà d'un jeu donné et non d'exercer une pression pour appliquer les surfaces libres des plots l'une contre l'autre.

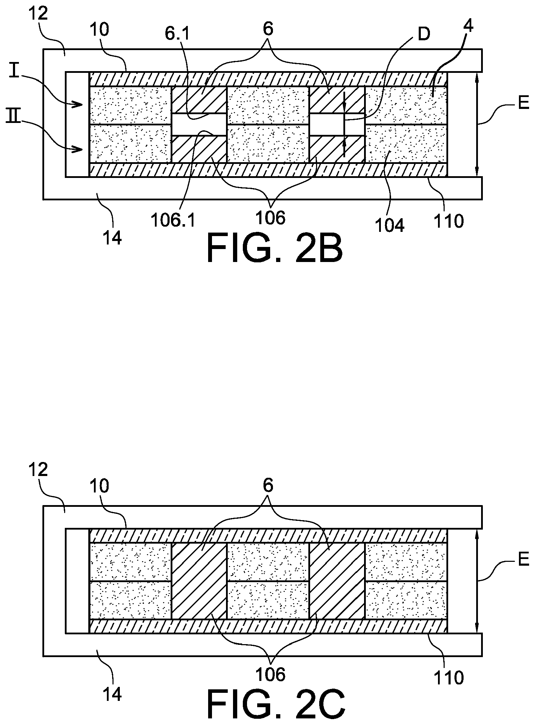

Sur la figure 2B, on peut voir les éléments I et II disposés entre les deux plaques de maintien 12 et 14 séparées de la distance fixe E. Dans cet exemple, les deux plaques 12 et 14 forment un ensemble rigide, dans lequel l'empilement des éléments est inséré. Le traitement thermique n'a pas encore commencé.

Lors de cette étape B), les plots de cuivre se dilatent et entrent en contact et un collage entre les plots a lieu. Sur la figure 2C, on peut voir que la distance D a été comblée.

La température du traitement thermique est typiquement comprise entre 50°C et 400°C et la durée du traitement est comprise entre 10 mn et 10 heures. La dilatation des plots est fonction de la température du traitement thermique. La température et la durée du traitement thermique sont choisies en fonction du dishing : plus le dishing est important, plus la température devra être élevée au moins lors d'une première phase du traitement thermique pour assurer une dilatation suffisante.

La température lors du traitement thermique n'est pas nécessairement constante et peut varier.

Les plaques de maintien 12, 14 ont une surface au moins égale à celle des faces arrière des éléments de sorte à assurer un maintien sur toute la surface de l'interface de collage.

Sur la variante représentée sur la figure 3, l'empilement peut être disposé entre deux pistons P1 et P2 actionnés de sorte à assurer uniquement un maintien des éléments l'un contre l'autre. La distance séparant les nez des deux pistons est alors comprise entre [e - 2 nm ; e +2 nm], de préférence entre [e - 1 nm; e + 2 nm] lors du traitement thermique. Le maintien peut également être assuré entre un piston et une table. Sur la figure 3, la distance D n'a pas encore été comblée parla dilatation des portions de cuivre.

Il peut être prévu avantageusement d'interposer entre les plaques ou pistons de maintien et les faces arrière des éléments une fine couche d'un matériau mou, par exemple un polymère, afin de compenser les aspérités des faces arrière des éléments assemblés. L'épaisseur du film est de l'ordre de quelques nm de sorte que le matériau devienne incompressible lorsqu'il est serré entre une plaque de maintien et la face arrière d'un élément.

Il peut arriver que l'un ou les éléments à assembler ne soit pas parfaitement plan, l'un ou les éléments présentant alors une courbure.

A la fin de l'étape de mise en contact, l'empilement est également courbé.

Il peut alors être prévu une étape de remise à plat de l'empilement avant ou pendant l'étape de traitement thermique. Pour cela, une force est appliquée sur l'empilement de sorte à annuler la courbure de l'empilement. La force qui peut alors être appliquée est au plus de 3 kN. A titre d'exemple, dans le cas d'un collage de wafer 200 mm, la courbure maximale est de l'ordre de 30 µm, la force à appliquer est alors au plus de 3 kN. En général, la courbure est de l'ordre de 10 µm et la force à appliquer est de l'ordre de 1 kN.

Cette force de remise à plat peut être appliquée par exemple par l'un des pistons qui appuie sur la zone convexe de l'empilement. Il est à noter que l'intensité de la force requise pour remettre à plat un empilement de deux éléments est très faible relativement à celle de l'effort de compression exercé lorsqu'une technique de thermocompression est mise en oeuvre.

L'étape de remise à plat peut être réalisée antérieurement à l'étape A, par exemple pour cela on réalise une remise à plat de l'élément courbé ou des deux éléments courbés.

Cette remise à plat peut être réalisée par des moyens d'aspiration qui viennent redresser le ou les éléments. Par exemple, il peut s'agir d'une table munie d'orifices dans lesquels est générée une dépression. Les moyens d'aspiration peuvent être utilisés également lorsque la remise à plat a lieu après l'étape A).

En variante, on peut prévoir un dispositif comportant une pluralité de logements superposés délimités chacun par deux surfaces séparées d'une distance E comprise entre [e - 2 nm ; e +2 nm], de préférence entre [e - 1 nm; e + 2 nm]. Chaque empilement est glissé dans un logement. Le dispositif de maintien collectif subit ensuite l'étape de traitement thermique. Lors de l'insertion des empilements dans les logements, ceux présentant une courbure subissent automatiquement une étape de remise à plat.

Il sera compris que ce dispositif collectif peut être mis en oeuvre dans le cas où les empilements ne présentent pas de courbure.

Alternativement, il peut être prévu de disposer par exemple sur une table plusieurs empilements côte à côte et d'appliquer collectivement un maintien en disposant une plaque unique à une distance comprise entre [e - 2 nm ; e +2 nm], de préférence entre [e - 1 nm; e + 2 nm] de la table.

Nous allons maintenant décrire des exemples d'assemblage dans lesquels l'étape de traitement thermique a lieu avec ou sans maintien afin de montrer l'intérêt de la présente invention.

Nous considérons lors de l'étape de collage un désalignement de 500 nm entre les deux wafers, i.e. entre les plots en regard.

Dans un premier exemple, il a été considéré un collage de deux plots carrés de cuivre de 3 µm de côté, de 500 nm de haut, avec un dishing de 10 nm sur chaque plot. Le traitement thermique a lieu à une température de 400°C.

A la fin de la première étape de collage à température ambiante, l'interface métallique entre les deux éléments n'est pas complètement fermée et l'écart maximal entre deux surfaces libres des plots en regard est de 19,2 nm.

Dans le cas d'un traitement thermique, sans maintien des éléments, l'écart entre les deux surfaces est de 7,9 nm à la fin du traitement thermique.

Lorsque les deux éléments sont assemblés selon le procédé selon l'invention, plus particulièrement lorsque, lors de l'étape de traitement thermique, les deux éléments sont maintenus l'un contre l'autre comme cela a été décrit ci-dessus, on constate qu'à la fin du traitement thermique, l'écart entre les deux surfaces est nul, l'écart de 19,2 nm entre les faces libres des plots en regard a été entièrement comblé.

Dans un deuxième exemple, il a été considéré un collage de deux lignes de cuivre de 3 µm de large, de 500 nm de haut, avec un dishing de 7 nm sur chaque plot.

Le traitement thermique a lieu à une température de 200°C.

A la fin de la première étape de collage à température ambiante, l'interface métallique entre les deux éléments n'est pas complètement fermée et l'écart maximal entre deux surfaces libres des plots est de 13,3 nm.

Dans le cas d'un traitement thermique, sans maintien des éléments, l'écart entre les deux surfaces est de 7,5 nm à la fin du traitement thermique.

Lorsque les deux éléments sont assemblés selon le procédé selon l'invention, plus particulièrement lorsque, lors de l'étape de traitement thermique, les deux éléments sont maintenus, on constate qu'à la fin du traitement thermique, l'écart entre les deux surfaces est nul, l'écart de 13,3 nm entre les faces libres des lignes a été entièrement comblé.

Dans un troisième exemple, il a été considéré un collage de deux lignes de cuivre de 10 µm de large, de 500 nm de haut, avec un dishing de 15 nm sur chaque plot. Le traitement thermique a lieu à une température de 400°C.

A la fin de la première étape de collage à température ambiante, l'interface métallique entre les deux éléments n'est pas complètement fermée et l'écart maximal entre deux surfaces libres des plots en regard est de 29,9 nm.

Dans le cas d'un traitement thermique, sans maintien des éléments, l'écart entre les deux surfaces est de 19,9 nm à la fin du traitement thermique.

Lorsque les deux éléments sont assemblés selon le procédé selon l'invention, plus particulièrement lorsque, lors de l'étape de traitement thermique, les deux éléments sont maintenus l'un contre l'autre, on constate qu'à la fin du traitement thermique, l'écart entre les deux surfaces est nul, l'écart de 29,9 nm entre les faces libres des lignes a été entièrement comblé.

Le deuxième exemple et le troisième exemple montrent qu'il est possible en utilisant l'invention soit de réduire la température du traitement thermique pour obtenir le collage à dishing initial donné, soit pour une même température de traitement thermique d'obtenir un collage pour des dishings plus importants.

Dans un quatrième exemple, il a été considéré un collage de deux lignes de cuivre de 10 µm de large, de 350 nm de haut, avec un dishing de 10 nm sur chaque plot. Le traitement thermique a lieu à une température de 400°C.

A la fin de la première étape de collage à température ambiante, l'interface métallique entre les deux éléments n'est pas complètement fermée et l'écart maximal entre deux surfaces libres des plots en regard est de 19,8 nm.

Dans le cas d'un traitement thermique sans maintien des éléments, l'écart entre les deux surfaces est de 18,9 nm à la fin du traitement thermique.

Lorsque les deux éléments sont assemblés selon le procédé selon l'invention, plus particulièrement lorsque, lors de l'étape de traitement thermique, les deux éléments sont maintenus l'un contre l'autre, on constate qu'à la fin du traitement thermique, l'écart entre les deux surfaces est nul, l'écart de 29,9 nm entre les faces libres des lignes a été entièrement comblé.

Ces exemples montrent l'efficacité du procédé d'assemblage par collage direct selon la présente invention par rapport au procédé d'assemblage par collage direct de l'état de la technique.

Dans les exemples décrits, les portions en cuivre des deux éléments à assembler présentent le même dishing. Généralement, les deux éléments étant préparés par les mêmes techniques, ils présentent des dishings proches voire égaux. Mais il sera compris que le procédé selon l'invention s'applique également à l'assemblage d'éléments dont les portions métalliques ont des dishings différents. De préférence, le dishing maximal cumulé des deux plots métalliques à assembler est inférieur ou égal à 40 nm.

Sur la figure 6, on peut voir représenté le déplacement Δ en µm de la zone centrale libre d'un plot de cuivre seul en fonction de son diamètre φ en µm lorsqu'il subit un traitement thermique à 200°C pour différentes hauteurs H du plot en µm. On constate que le déplacement de la surface libre du plot est proportionnel à son diamètre et à sa hauteur, c'est-à dire au volume du matériau du plot. Ces mesures n'ont pas été faites dans le cadre du procédé selon l'invention. Elles permettent d'avoir une première idée pour une température donnée de la quantité de matériau requise pour combler un dishing donné.

Dans le procédé d'assemblage selon l'invention, dans lequel les deux éléments sont maintenus au moins dans une première phase du traitement thermique, le déplacement des surfaces libres est amplifié et permet de combler des dishings plus importants.

Il sera également compris que la présente invention s'applique à l'assemblage d'un élément I ou I' tel que décrit et d'un autre élément formé par exemple d'une surface entièrement métallique ou entièrement formé d'un matériau diélectrique.

Grâce à la présente invention, il est possible de réaliser un traitement thermique à plus basse température ou alors d'accepter un dishing plus important sans changer la température du traitement thermique. Il est ainsi possible de régler la température du traitement thermique en fonction du dishing, ce qui permet très avantageusement d'ajuster les coûts énergétiques. En outre dans le domaine micro et nanoélectronique, cela peut permettre de réduire les températures auxquelles sont soumises les éléments évitant une détérioration de ceux-ci.

Selon une variante de réalisation, lors de l'étape de traitement thermique, les éléments sont maintenus uniquement pendant une première phase puis, lors d'une deuxième phase, le maintien est supprimé et le traitement thermique se poursuit à la même température ou à une température différente.

Par exemple, lors d'une première phase, la température peut être de 400°C pendant 10 mn puis lors d'une deuxième phase la température est de 200°C pendant plusieurs heures. Il est ainsi possible de limiter la période pendant laquelle les éléments sont soumis à une température élevée.

Cette variante permet par exemple de réaliser une première phase de traitement thermique individuelle et une deuxième phase de traitement thermique collective.

De manière avantageuse, l'étape A et/ou l'étape B peuvent être réalisées sous vide. Lors de l'étape A, la mise en contact sous vide permet d'éviter de piéger des bulles d'air et plus généralement de gaz entre au niveau du ou des dishings.

L'étape B peut également être réalisée sous vide ainsi, si lors de l'étape A le collage au niveau du diélectrique n'est pas suffisant pour isoler les zones de dishing, le vide est maintenu jusqu'à ce que le scellement soit complet.

La présente invention présente l'avantage de permettre de compenser des disparités de dishing entre les différents plots des éléments à assembler.

## Revendications

1. Procédé d'assemblage par collage direct d'un premier (I) et d'un deuxième (II) élément munis chacun d'une face arrière (10, 110) et d'une surface d'assemblage (8, 108), au moins la surface d'assemblage (8) du premier élément comportant au moins une portion au moins en partie métallique (6, 106) entourée par au moins un matériau diélectrique (4, 104), ladite portion métallique (6) présentant une surface libre (6.1) en retrait par rapport au matériau diélectrique (4) au niveau de ladite surface d'assemblage (8), ledit procédé comportant :
A) une étape de mise en contact des deux surfaces d'assemblage (8, 108) sans application de pression de sorte qu'un collage direct soit obtenu entre les surfaces d'assemblage (8, 108), ladite étape ayant lieu à au moins une première température, lesdits premier et deuxième ensembles (I, II) formant un empilement présentant une épaisseur (e),
B) une étape de traitement thermique dudit empilement à au moins une deuxième température,
**caractérisé en ce que**, pendant au moins une première phase de l'étape B), les faces arrière (10, 110) des premier (I) et deuxième (II) éléments sont immobilisées de sorte qu'elles soient maintenues à distance fixe (E) comprise entre l'épaisseur de l'empilement (e) - 2 nm et l'épaisseur de l'empilement (e) + 2 nm.

2. Procédé d'assemblage selon la revendication 1, dans lequel lors de l'étape B), les faces arrière (10, 110) des premier (I) et deuxième (II) éléments sont immobilisées de sorte qu'elles soient maintenues à distance fixe comprise entre l'épaisseur de l'empilement (e) - 1 nm et l'épaisseur de l'empilement (e) + 1 nm.

3. Procédé d'assemblage selon la revendication 1 ou 2, dans lequel la surface d'assemblage du deuxième élément (II) comporte au moins une portion au moins en partie métallique (106) entourée par au moins un matériau diélectrique (104), ladite portion métallique (106) présentant une surface libre (106.1) en retrait par rapport au matériau diélectrique (104) au niveau de ladite surface d'assemblage (108), et dans lequel, lors de l'étape A), la mise en contact est réalisée de sorte à aligner la portion métallique (6) de ladite surface d'assemblage du premier élément et la portion métallique (106) de ladite surface d'assemblage du deuxième élément.

4. Procédé d'assemblage selon l'une des revendications 1 à 3, dans lequel lors de l'étape B), l'empilement est disposé entre deux dispositifs de maintien (12, 14) destinés à être en contact plan contre les faces arrière des premier et deuxième éléments, la distance séparant les deux dispositifs de maintien (12, 14) étant comprise entre l'épaisseur de l'empilement (e) - 2 nm et l'épaisseur de l'empilement (e) + 2 nm.

5. Procédé d'assemblage selon l'une des revendications 1 à 4, dans lequel la deuxième température du traitement thermique est réglée en fonction du retrait des portions métalliques (6, 106) par rapport au matériau diélectrique au niveau des surfaces d'assemblages (8, 108).

6. Procédé d'assemblage selon l'une des revendications 1 à 5, dans lequel le retrait des surfaces des portions métalliques par rapport à la surface de matériau diélectrique est inférieur ou égal à 20 nm.

7. Procédé d'assemblage selon l'une des revendications 1 à 6, dans lequel l'étape A) a lieu à température ambiante et à pression atmosphérique.

8. Procédé d'assemblage selon l'une des revendications 1 à 7, dans lequel la au moins deuxième température de l'étape de traitement thermique est comprise entre 50°C et 400°C.

9. Procédé d'assemblage selon l'une des revendications 1 à 8, l'empilement présentant une courbure, ledit procédé comportant une étape de remise à plat de l'empilement avant ou après l'étape A) et avant et/ou pendant le traitement thermique afin de supprimer ladite courbure.

10. Procédé d'assemblage selon la revendication précédente, dans lequel une force d'intensité de valeur inférieure à 3 kN est appliquée à l'empilement de sorte à supprimer la courbure.

11. Procédé d'assemblage selon l'une des revendications précédentes, dans lequel, préalablement à l'étape A), a lieu :
a) au moins une étape de polissage des surfaces d'assemblage de sorte que les surfaces présentent une rugosité inférieure à 0,7 nm RMS, et une hydrophilie inférieure à 20°.

12. Procédé d'assemblage selon l'une des revendications 1 à 11, dans lequel lors de l'étape B), les faces arrière (10, 110) des premier (I) et deuxième (II) éléments sont maintenues à la distance fixe (E) pendant une première phase et le maintien est supprimé pendant une deuxième phase, la deuxième phase pouvant se dérouler à la même température ou à une température différente de celle de la première phase.

13. Procédé d'assemblage selon l'une des revendications 1 à 12 pris en combinaison avec la revendication 4, les surfaces desdits dispositifs de maintien (12, 14) sont au moins égales à la surface des faces arrière des premier et deuxième éléments.

14. Procédé d'assemblage selon l'une des revendications 1 à 13, dans lequel les portions métalliques (6, 106) sont en cuivre, en aluminium, en tungstène ou en titane et le matériau diélectrique est un oxyde ou un nitrure , tel que SiO₂, SiOCH, Si₃N₄, ou Al₂O₃.

15. Procédé d'assemblage selon l'une des revendications 1 à 14, dans lequel plusieurs premiers éléments sont assemblés à plusieurs deuxièmes éléments simultanément.

16. Procédé d'assemblage selon l'une des revendications 1 à 15, dans lequel le premier et le deuxième élément sont des substrats microélectroniques et/ou nanoélectroniques, les portions métalliques (6, 106) formant des interconnexions électriques.

## Patentansprüche

1. Montageverfahren durch direktes Verkleben eines ersten (I) und eines zweiten (II) Elements, jeweils versehen mit einer Rückseite (10, 110) und einer Montagefläche (8, 108), wobei wenigstens die Montagefläche (8) des ersten Elements wenigstens einen wenigstens teilweise metallischen Teil (6, 106) umfasst, der von wenigstens einem dielektrischen Material (4, 104) umgeben ist, wobei der metallische Teil (6) eine freie Fläche (6.1.) umfasst, welche an der Montagefläche (8) von dem dielektrischen Material (4) zurückgesetzt ist, wobei das Verfahren umfasst:
A) einen Schritt des Inkontaktbringens der beiden Montageflächen (8, 108) ohne Ausübung von Druck, sodass ein direktes Verkleben zwischen den Montageflächen (8, 108) erreicht wird, wobei der Schritt bei wenigstens einer ersten Temperatur stattfindet, wobei die ersten und zweiten Verbünde (I, II) einen Stapel bilden, der eine Dicke (e) aufweist,
B) einen Schritt der Wärmebehandlung des Stapels bei wenigstens einer zweiten Temperatur,
**dadurch gekennzeichnet, dass**
während wenigstens einer ersten Phase des Schrittes B) die Rückseiten (10, 110) des ersten (I) und zweiten (II) Elements derart immobilisiert werden, dass sie in einem festen Abstand (E) zwischen der Dicke des Stapels (e) - 2 nm und der Dicke des Stapels (e) + 2 nm gehalten werden.

2. Montageverfahren nach Anspruch 1, bei welchem in Schritt B) die Rückseiten (10, 110) des ersten (I) und zweiten (II) Elements derart immobilisiert werden, dass sie in einem festen Abstand zwischen der Dicke des Stapels (e) - 1 nm und der Dicke des Stapels (e) + 1 nm gehalten werden.

3. Montageverfahren nach Anspruch 1 oder 2, bei welchem die Montagefläche des zweiten Elements (II) wenigstens einen wenigstens teilweise metallischen Teil (106) umfasst, der von wenigstens einem dielektrischen Material (104) umgeben ist, wobei der metallische Teil (106) eine freie Fläche (106.1) umfasst, welche an der Montagefläche (108) von dem dielektrischen Material (104) zurückgesetzt ist, und bei welchem im Schritt (A) das Inkontaktbringen derart ausgeführt wird, dass der metallische Teil (6) der Montagefläche des ersten Elements und der metallische Teil (106) der Montagefläche des zweiten Elements miteinander ausgerichtet werden.

4. Montageverfahren nach einem der Ansprüche 1 bis 3, bei welchem in Schritt B) der Stapel zwischen zwei Haltevorrichtungen (12, 14) angeordnet wird, die dazu ausgebildet sind, in flächiger Berührung mit den Rückseiten des ersten und zweiten Elements zu stehen, wobei der Abstand zwischen den beiden Haltevorrichtungen (12, 14) zwischen der Dicke des Stapels (e) - 2 nm und der Dicke des Stapels (e) + 2 nm liegt.

5. Montageverfahren nach einem der Ansprüche 1 bis 4, bei welchem die zweite Temperatur der Wärmebehandlung abhängig von dem Versatz der metallischen Teile (6, 106) im Verhältnis zum dielektrischen Material bezüglich der Montageflächen (8, 108) geregelt wird.

6. Montageverfahren nach einem der Ansprüche 1 bis 5, bei welchem der Versatz der Flächen der metallischen Teile von der Fläche des dielektrischen Materials kleiner gleich 20 nm ist.

7. Montageverfahren nach einem der Ansprüche 1 bis 6, bei welchem der Schritt A) bei Raumtemperatur und atmosphärischem Druck durchgeführt wird.

8. Montageverfahren nach einem der Ansprüche 1 bis 7, bei welchem die wenigstens zweite Temperatur des Schritts der Wärmebehandlung zwischen 50°C und 400 °C liegt.

9. Montageverfahren nach einem der Ansprüche 1 bis 8, wobei der Stapel eine Krümmung aufweist, wobei das Verfahren einen Schritt des in den flachen Zustand Bringens des Stapels vor oder nach Schritt A) und vor und/oder während der Wärmebehandlung umfasst, um die Krümmung zu beseitigen.

10. Montageverfahren nach dem vorhergehenden Anspruch, bei welchem eine Kraft mit einem Wert unter 3 kN auf den Stapel ausgeübt wird, um die Krümmung zu beseitigen.

11. Montageverfahren nach einem vorhergehenden Ansprüche, bei welchem vor Schritt A) erfolgt:
(a) wenigstens ein Schritt des Polierens der Montageflächen derart, dass die Flächen eine Rauheit kleiner 0,7 nm RMS und eine Hydrophilie kleiner 20° aufweisen.

12. Montageverfahren nach einem der Ansprüche 1 bis 11, bei welchem in Schritt B) während einer ersten Phase die Rückseiten (10, 110) des ersten (I) und zweiten (II) Elements mit dem festen Abstand (E) gehalten werden und das Halten während einer zweiten Phase entfällt, wobei die zweite Phase bei der gleichen Temperatur oder bei einer von der Temperatur der ersten Phase verschiedenen Temperatur stattfinden kann.

13. Montageverfahren nach einem der Ansprüche 1 bis 12 in Kombination mit Anspruch 4, wobei die Flächen der Haltevorrichtungen (12, 14) wenigstens gleich der Fläche der Rückseiten des ersten und zweiten Elements sind.

14. Montageverfahren nach einem der Ansprüche 1 bis 13, bei welchem die metallischen Teile (6, 106) aus Kupfer, Aluminium, Wolfram oder Titan sind und das dielektrische Material ein Oxid oder ein Nitrid ist, wie beispielsweise SiO₂, SiOCH, Si₃N₄ oder Al₂O₃.

15. Montageverfahren nach einem der Ansprüche 1 bis 14, bei welchem mehrere erste Elemente gleichzeitig mit mehreren zweiten Elementen zusammengefügt werden.

16. Montageverfahren nach einem der Ansprüche 1 bis 15, bei welchem das erste und das zweite Element mikroelektronische und/oder nanoelektrische Substrate sind, wobei die metallischen Teile (6, 106) elektrische Verbindungen miteinander bilden.

## Claims

1. Method of assembly of a first element (I) and a second element (II) each having a back face (10, 110) and an assembly surface (8, 108) by direct bonding, , at least the assembly surface (8) of the first element comprising at least one portion with at least one metal part (6, 106) surrounded by at least one dielectric material (4, 104), said metal portion (6) having a free surface (6.1) recessed from the dielectric material (4) at said assembly surface (8), said method comprising:
A) a step to bring the two assembly surfaces into contact (8, 108) without application of pressure such that direct bonding is obtained between the assembly surfaces (8, 108), said step taking place at at least one first temperature, said first and second assemblies (I, II) forming a stack with a thickness (e),
B) a heat treatment step of said stack at at least one second temperature,
**Characterized in that**, during at least a first phase of step B), the back faces (10, 110) of the first (I) and the second elements (II) are held in position so that they are held at a fixed distance (E) between the stack thickness (e) - 2 nm and the stack thickness (e) + 2 nm.

2. Assembly method according to claim 1, in which during step B), the back faces (10, 110) of the first (I) and second (II) elements are held in position such that they are held at a fixed distance between the stack thickness (e) - 1 nm and the stack thickness (e) + 1 nm.

3. Assembly method according to claim 1 or 2, in which the assembly surface of the second element (II) comprises at least one portion that is at least partly metallic (106) surrounded by at least one dielectric material (104), said metal portion (106) having a free surface (106.1) recessed from the dielectric material (104) at said assembly surface (108), and in which contact is made during step A) so as to align the metal portion (6) of said assembly surface of the first element and the metal portion (106) of said assembly surface of the second element.

4. Assembly method according to one of claims 1 to 3, in which during step B), the stack may be placed between two holding devices (12, 14) that will be in plane contact with the back faces of the first and second elements, the distance separating the two holding devices (12, 14) being between the stack thickness (e) - 2 nm and the stack thickness (e) + 2 nm.

5. Assembly method according to one of claims 1 to 4, in which the second heat treatment temperature is adjusted as a function of the recess of the metal portions (6, 106) from the dielectric material at the assembly surfaces (8, 108).

6. Assembly method according to one of claims 1 to 5, in which the recess of the surfaces of the metal portions from the surface of dielectric material is less than or equal to 20 nm.

7. Assembly method according to one of claims 1 to 6, in which step A) advantageously takes place at ambient temperature and atmospheric pressure.

8. Assembly method according to one of claims 1 to 7, in which the at least one second temperature in the heat treatment step is between 50°C and 400°C.

9. Assembly method according to one of claims 1 to 8, said stack being curved, said method comprises a stack flattening step before or after step A) and before and/or during the heat treatment in order to eliminate said curvature.

10. Assembly method according to the previous claim, in which a force of less than 3 kN is applied to the stack so as eliminate the curvature.

11. Assembly method according to one of the previous claims, in which, before step A), there is advantageously:
a) at least one assembly surface polishing step such that the roughness of the surfaces is less than 0.7 nm RMS, and hydrophily is less than 20°.

12. Assembly method according to one of claims 1 to 11, in which during step B), the back faces (10, 110) of the first (I) and second (II) elements are held in place at the fixed distance (E) during a first phase and they are no longer held in place during a second phase, the second phase possibly taking place at the same temperature as the first phase or at a different temperature.

13. Assembly method according to one of claims 1 to 12 combined with claim 4, the surfaces of said holding devices (12, 14) are at least as large as the surface area of the back faces of the first and second elements.

14. Assembly method according to one of claims 1 to 13, in which the metal portions (6, 106) are made of copper, aluminum, tungsten or titanium, and the dielectric material is an oxide or a nitride such as SiO₂, SiOCH, Si₃N₄ or Al₂O₃.

15. Assembly method according to one of claims 1 to 14, in which several first elements are assembled to several second elements simultaneously.

16. Assembly method according to one of claims 1 to 15, in which the first and the second elements are microelectronic and/or nanoelectronic substrates, the metal portions (6, 106) forming electrical interconnections.
